# FASCICULE DE BREVET EUROPEEN

(11) **EP 0 609 126 B1**
(45) Date de publication et mention de la délivrance du brevet: **26.03.1997**
(21) Numéro de dépôt: 94400142.9
(22) Date de dépôt: 24.01.1994
(51) Int. Cl.: H01S 3/085, H01S 3/025, H01S 3/137

(54) **Laser à semiconducteur à deux sélecteurs passifs en longueur d'onde**
Halbleiterlaser mit zwei passiven Wellenlängenselektoren
Semiconductor laser with two passive wavelength selectors

(30) Priorité: 26.01.1993 FR 9300722
(43) Date de publication de la demande: 03.08.1994
(73) Titulaire: FRANCE TELECOM, 75015 Paris (FR)
(72) Inventeur: Auzel, François, F-78320 Le Mesnil-St-Denis (FR); Zhou, Bei Wen, F-78180 Montigny le Bretonneux (FR)
(74) Mandataire: Signore, Robert

(56) Documents cités:
- EP-A- 0 402 249
- FR-A- 2 331 040
- JOURNAL OF APPLIED PHYSICS., vol.69, no.10, 15 Mai 1991, NEW YORK US pages 7310 - 7312 F. AUZEL ET AL. 'Passive wavelength stabilization in the 1.5 mum region of wide gain spectrum lasers by Er3+ doped materials'

## Description

### Domaine technique

La présente invention a pour objet un laser à semiconducteur avec deux sélecteurs passifs en longueur d'onde.

Elle trouve une application en télécommunications optiques. Elle s'applique à tous les lasers à semiconducteur et notamment aux lasers à simple ou à double hétérostructure en alliage III-V. Il peut s'agir, par exemple, mais non exclusivement, de lasers à GaAs, GaAlAs, InGaAs, GaAsP, InGaAsP, InP, etc...

### Etat de la technique antérieure

Dans le domaine des télécommunications optiques, il existe un réel besoin de sources laser offrant une grande stabilité de fréquence. Ce n'est qu'à cette condition qu'on pourra mettre en oeuvre les techniques de la radioélectricité comme la modulation, la démodulation, etc...

La stabilisation en fréquence des lasers en général et des lasers à semiconducteur en particulier, est une technique largement connue aujourd'hui. Plusieurs solutions ont déjà été proposées : asservissement de la fréquence à un mode de résonance d'un étalon FABRY-PEROT ou à une raie d'absorption d'un gaz, synchronisation sur un autre laser lui-même stabilisé, etc...

Pour faciliter l'obtention de cette stabilité, le laser à stabiliser est choisi ou modifié pour présenter déjà une certaine stabilité de fréquence. On peut par exemple opérer par tri de doubles hétérostructures pour ne retenir que les composants dont l'alliage conduit à la fréquence centrale souhaitée ; il est également possible de réduire la largeur propre d'émission en allongeant la cavité résonante au moyen d'un miroir auxiliaire extérieur (contre-réaction optique) ; on peut enfin avoir recours à un réseau de diffraction disposé le long de la zone active (laser dit "DFB" pour "Distributed Feed-Back" ou encore "DBR" pour "Distributed Bragg Reflection").

Cet état de la technique est décrit, par exemple, dans l'article de Motoichi OHTSU intitulé "Frequency Stabilization in Semi-Conductors Lasers" publié dans la revue "Optical and Quantum Electronics", vol. 20, (1988), pages 283-300.

Cependant, ces techniques connues présentent des inconvénients. La méthode du tri des hétérostructures conduit à des rendements de fabrication bas. Le recours à la contre-réaction optique par miroir auxiliaire externe pose des problèmes mécaniques difficiles et conduit à des structures complexes et lourdes de mise en oeuvre. Quant aux lasers à réseaux distribués le long de la zone active, ils ne sont obtenus qu'au prix d'une complication de la fabrication, due à des reprises d'épitaxie ; d'où des coûts relativement élevés.

On connaît, par ailleurs, des lasers à semiconducteurs utilisant un sélecteur en longueur d'onde, sélecteur constitué par un cristal dopé avec des ions de terre rare. La demande de brevet français FR-A-2 648 281 décrit un tel laser. Dans un tel dispositif, la sélection est fondée sur le mécanisme suivant. Les ions de terre rare possèdent un état fondamental et un premier état électronique excité. Du fait du champ électrique créé par le réseau cristallin, ces niveaux sont décomposés en sous-niveaux (effet Stark). Les ions présentent alors des séries de raies d'absorption correspondant à des transitions de l'état fondamental vers l'état excité et des raies d'émission correspondant à des transitions inverses. Ces deux séries de raies sont légèrement décalées l'une par rapport à l'autre, les raies d'émission se situant à une énergie un peu plus faible, donc à une longueur d'onde un peu plus grande.

Toujours selon ce document FR-A-2 648 281, on choisit la composition du cristal et la nature des ions pour que les plages d'absorption et d'émission tombent dans la bande d'émission spontanée du milieu amplificateur semiconducteur. Il se produit alors un transfert d'énergie des plus courtes longueurs d'onde vers les plus grandes. La longueur d'onde de la raie d'émission la plus intense de l'ion terre rare se trouve être privilégiée et c'est sur cette longueur d'onde que le laser va osciller.

Il s'agit donc d'un moyen sélectif que l'on peut qualifier d'actif, en ce sens que la longueur d'onde finalement émise est directement imposée par le cristal dopé.

Bien que donnant satisfaction à certains égards, ce type de lasers reste assez difficile à réaliser en raison de la double condition imposée au cristal dopé, à savoir que son spectre d'absorption et son spectre d'émission tombent dans une plage appropriée.

Par ailleurs, l'article intitulé "Passive wavelength stabilization in the 1.5 µm region of wide gain spectrum lasers by Er³⁺⁻ doped materials" de F. AUZEL et al., publié dans la revue Journal of Applied Physics, n°69 (10) 15 may 1991, pp 7310-7312 décrit un moyen de sélection qui peut être fondée sur un mécanisme d'absorption simple si la densité de photons est inférieure à un certain seuil.

Bien que présentant un certain intérêt, cette technique, telle que décrite dans le document, ne permet pas d'ajuster la longueur d'onde d'émission du laser à une valeur choisie.

La présente invention a justement pour but de remédier à cet inconvénient.

FR-A-2 331 040 décrit un filtre optique ayant une première et une seconde résonance d'absorption provenant d'espèces de différentes atomes de terres rares à couches 4f partiellement remplies, l'absorption du côté des courtes longueurs d'onde de la première résonance définissant la limite des grandes longueurs d'onde de la bande passante du filtre, et l'absorption du côté des grandes longueurs d'onde de la seconde résonance définissant la limite des courtes longueurs d'onde de la bande passante du filtre.

### Exposé de l'invention

Selon l'invention, on utilise toujours le mécanisme d'absorption mais avec deux sélecteurs constitués par deux matériaux différents. Ces deux matériaux auront des spectres d'absorption présentant deux creux décalés l'un par rapport à l'autre, l'ensemble de ces deux matériaux donnant un spectre définissant un creux d'absorption globale définissant la longueur d'onde d'émission du laser.

De façon plus précise, la présente invention a pour objet un laser à semi-conducteur comprenant :
- un milieu amplificateur présentant un certain gain d'amplification dans une certaine plage de longueur d'onde,
- au moins un miroir,
- au moins un sélecteur de longueur d'onde constitué par un matériau contenant une terre rare, ce sélecteur étant disposé entre le miroir et le milieu amplificateur, ce matériau présentant un spectre d'absorption avec un creux à une certaine longueur d'onde tombant dans la plage d'amplification, ce creux correspondant à une absorption inférieure au gain d'amplification du milieu amplificateur,
caractérisé par le fait qu'il comprend deux sélecteurs constitués de deux matériaux différents contenant des terres rares, ces deux matériaux ayant deux spectres d'absorption présentant deux creux décalés l'un par rapport à l'autre, l'ensemble de ces deux matériaux donnant un spectre définissant un creux d'adsorption globale définissant une longueur d'onde qui est la longueur d'onde d'émission du laser.

De préférence, le creux d'absorption de chaque sélecteur présentant une certaine largeur à hauteur égale à 1,1 DO min, DO min étant la densité optique au minimum d'absorption, l'inverse de cette largeur étant au moins égal à 2.10⁶ cm⁻¹.

Les deux matériaux peuvent être constitués par une même matrice avec deux types d'ions de terre rare différents ou par un même type d'ions de terre rare et deux matrices différentes.

On peut aussi utiliser un seul matériau constitué par une matrice contenant un mélange d'ions de deux terres rares différentes.

Quant à la matrice contenant les ions terres-rares il peut s'agir d'un cristal ou d'un verre ou de toute autre substance transparente à la longueur d'onde de travail.

Quant aux ions de terre rare, ils peuvent être choisis dans le groupe constitué par Er³⁺, Sm³⁺, Pr³⁺ et Nd³⁺.

La concentration de cette terre rare peut être supérieure à environ 10²¹ cm⁻³.

### Brève description des dessins

- la figure 1 illustre le principe d'une sélection par absorption ;
- la figure 2 permet de définir le facteur de mérite d'un matériau absorbant,
- la figure 3 illustre un exemple d'utilisation de deux matériaux différents ;
- la figure 4 montre un mode de réalisation du laser selon l'invention ;
- la figure 5 montre un autre mode de réalisation du laser selon l'invention ;
- la figure 6 montre encore un autre mode de réalisation du laser selon l'invention ;
- la figure 7 montre encore un autre mode de réalisation du laser selon l'invention à structure compacte ;
- la figure 8 est un spectre d'émission d'un laser classique ;
- la figure 9 est un spectre d'émission d'un laser perfectionné selon l'invention.

### Exposé détaillé de modes de réalisation

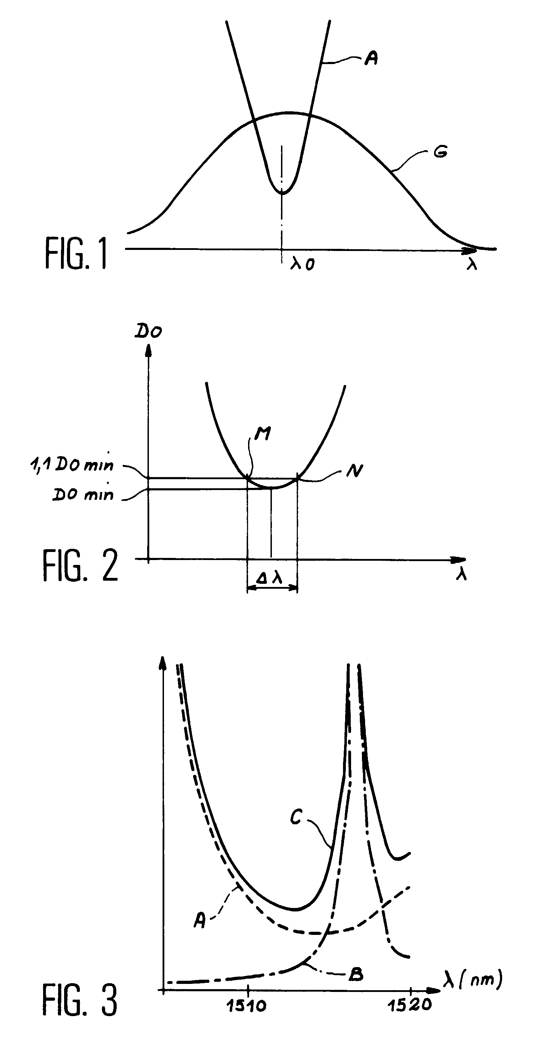

La figure 1 est un schéma théorique montrant la courbe G des variations de l'amplification optique produite par la structure semiconductrice d'un laser et la courbe A d'absorption produite par un sélecteur. Les pertes dues aux miroirs ou aux faces de la structure ne sont pas prises en compte dans ce schéma simplifié.

Dans le creux de la courbe A, l'absorption est inférieure au gain G et l'oscillation est possible. Le laser émet donc à une longueur d'onde λₒ située dans ce creux. En dehors de celui-ci, l'absorption l'emporte sur le gain et l'oscillation est impossible.

La figure 2 montre la densité optique D0 d'un matériau, portée en ordonnées, en fonction de la longueur d'onde λ, portée en abscisses. Cette figure permet de définir un facteur de mérite M pour tout matériau sélectif. Au minimum d'absorption, la densité optique prend la valeur DOₘᵢₙ. Une densité optique égale à 1,1 DOₘᵢₙ est obtenue pour deux points M et N écartés en longueur d'onde de la valeur Δλ. On définit alors le facteur de mérite comme la quantité M=1/Δλ.

Selon l'invention, on choisira, de préférence, pour ce facteur de mérite, une valeur au moins égale à 2.10⁶ cm⁻¹, par exemple 3.10⁶ cm⁻¹.

La figure 3 montre le spectre d'absorption d'un cristal de LiErF₄ de 200 µm d'épaisseur, orienté "π" (courbe A), celui d'un échantillon de ErAl_{4,5}Ga_{0,5}O₁₂ de 216 µm d'épaisseur (courbe B) et celui des deux échantillons combinés (courbe C).

On voit que la courbe C présente un creux très marqué vers 1512 nm alors que les courbes A et B ne présentaient que des variations très plates dans cette région.

D'une manière générale, par matériaux différents on entend soit un même ion terre rare dans deux matrices différentes, soit une même matrice contenant deux ions soit une combinaison des ions Er³⁺, Sm³⁺, Pr³⁺ ou Nd³⁺. Les transitions de ces ions sont respectivement ⁴I_{15/2→} ⁴I_{13/2} ⁶H_{5/2→} ⁶H_{3/2} ³H_{4→} ³F₃ ⁴I_{9/2→} ⁴I/_{15/2}. Elles se font dans la zone spectrale s'étendant de 1,4 à 1,6 µm. Toutes ces transitions ont la particularité de correspondre à une absorption à partir des états fondamentaux dans lesquels se trouvent les ions en l'absence d'excitation.

Dans le cas de deux matrices différentes dopées avec un même ion, en jouant sur les épaisseurs et les concentrations respectives des deux matrices, il est possible de déplacer la place du creux d'absorption, ce qui permet de prédéterminer la longueur d'onde sélectionnée.

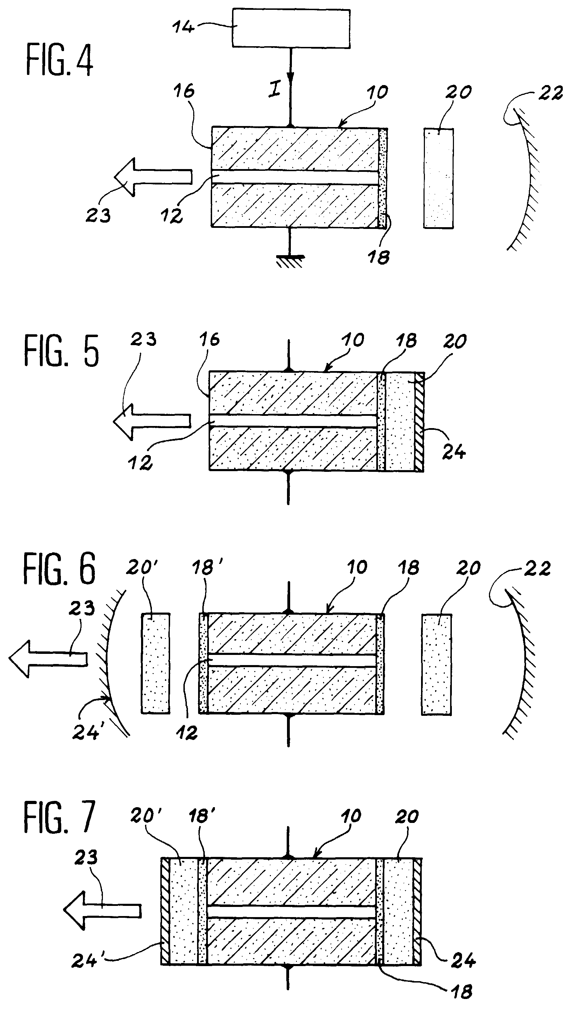

Les figures 4 à 7 montrent plusieurs modes de réalisation possibles d'un laser conforme à l'invention. Mais l'homme du métier pourra en imaginer d'autres.

Le laser illustré sur la figure 4 tout d'abord comprend un milieu amplificateur 10 en forme de double hétérostructure avec une jonction PN référencée 12. La structure semiconductrice est alimentée en courant par une source 14. La face avant 16 de l'hétérostructure est clivée. La face arrière est recouverte d'une couche anti-reflet 18. Une lame mince 20 de cristal dopé en ions de terre rare définie selon les conditions exposées plus haut est disposée entre la couche anti-reflet 18 et un miroir sphérique 22. L'émission cohérente s'effectue par l'avant (référence 23).

Dans une variante plus compacte, illustrée par la figure 5, la lame mince cristalline dopée 20 est plaquée sur la couche anti-reflet 18 et une couche réfléchissante 24 est déposée sur la face arrière de la lame 20.

Sur la figure 6, le laser comprend les mêmes éléments que sur la figure 4 mais avec une deuxième lame cristalline dopée 20' et un miroir semi-réfléchissant 24'. Dans ce cas, la structure semiconductrice comprend, sur sa face clivée avant, des couches anti-reflet 18'.

Enfin, dans une structure très compacte est illustrée sur la figure 7 où tous les éléments 10, 20, 20' sont assemblés les uns aux autres. Une couche réfléchissante 24 est déposée à l'arrière de l'ensemble et une couche semi-réfléchissante 24' à l'avant.

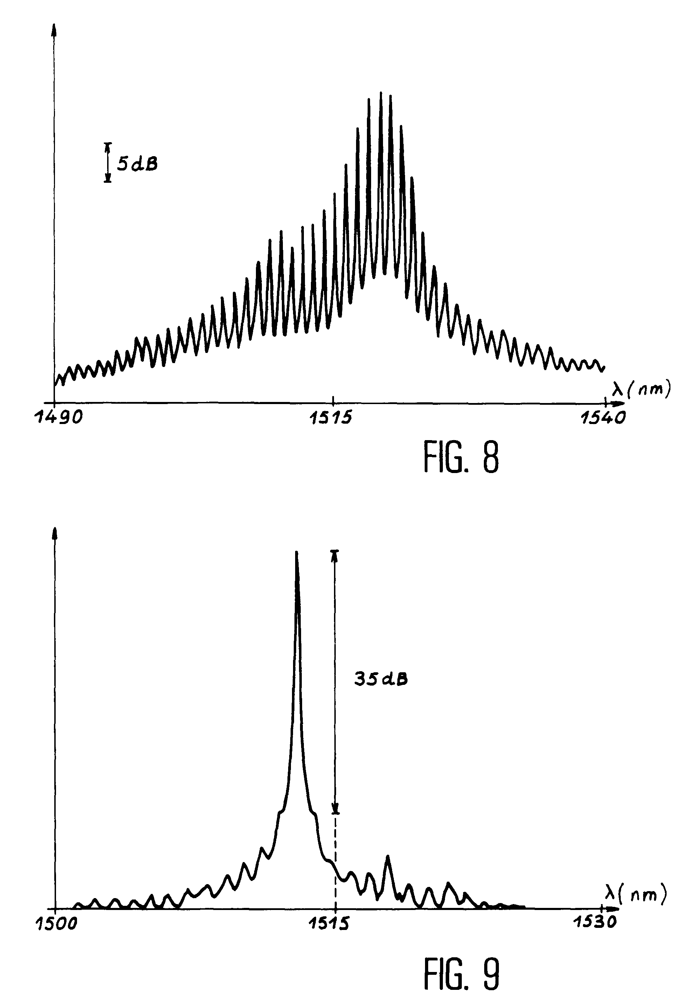

Pour illustrer les performances de l'invention, les figures 8 et 9 donnent le spectre d'émission d'un laser conforme à l'art antérieur (fig. 8) et celui d'un laser conforme à l'invention (fig. 9). La figure 8 correspond à un laser en InGaAsP de type FABRY-PEROT. Le spectre d'émission est très large et de nombreux modes longitudinaux sont visibles. Le spectre d'émission s'étend d'environ 1490 à 1540 nm.

Après dépôt de couches anti-reflet sur les deux faces, on applique des lamelles de LiErF₄ de 200 µm d'épaisseur sur une face et de Er₃Al_{4,5}Ga_{0,5}O₁₂ de 200 µm d'épaisseur sur l'autre face. Le spectre obtenu est alors celui de la figure 9. Il est monofréquence à 1512 nm.

## Revendications

1. Laser à semi-conducteur comprenant :
- un milieu amplificateur (10) présentant un certain gain d'amplification (G) dans une certaine plage de longueur d'onde,
- au moins un miroir (22),
- au moins un sélecteur de longueur d'onde constitué par un matériau contenant une terre rare, ce sélecteur étant disposé entre le miroir (22) et le milieu amplificateur (12), ce matériau présentant un spectre d'absorption (A) avec un creux à une certaine longueur d'onde tombant dans la plage d'amplification, ce creux correspondant à une absorption inférieure au gain d'amplification du milieu amplificateur (10),
caractérisé par le fait qu'il comprend deux sélecteurs constitués de deux matériaux différents (20, 20') contenant des terres rares, ces deux matériaux ayant deux spectres d'absorption (A, B) présentant deux creux décalés l'un par rapport à l'autre, l'ensemble de ces deux matériaux donnant un spectre (C) définissant un creux d'absorption globale définissant une longueur d'onde (λ0) qui est la longueur d'onde d'émission du laser.

2. Laser selon la revendication 1, caractérisé par le fait que le creux d'absorption de chaque sélecteur présente une certaine largeur (Δλ) à hauteur égale à 1,1 DO min, DO min étant la densité optique au minimum d'absorption, l'inverse (M=1/(Δλ)) de cette largeur étant au moins égal 2.10⁶ cm⁻¹.

3. Laser selon la revendication 1, caractérisé par le fait que les deux matériaux (20, 20') sont constitués par une même matrice avec deux types d'ions de terre rare différents pour les deux matériaux.

4. Laser selon la revendication 1, caractérisé par le fait que les deux matériaux (20, 20') sont constitués par un même type d'ions de terre rare et deux matrices différentes pour les deux matériaux.

5. Laser selon la revendication 1, caractérisé par le fait qu'il contient un seul matériau (20) constitué par une matrice contenant un mélange d'ions de deux terres rares différentes.

6. Laser selon la revendication 1, caractérisé par le fait que le matériau de chaque sélecteur est un cristal dopé par des ions de terre rare.

7. Laser selon la revendication 1, caractérisé par le fait que le matériau de chaque sélecteur est un verre dopé par des ions de terre rare.

8. Laser selon l'une quelconque des revendications 1 à 6, caractérisé par le fait que les ions de terre rare sont pris dans le groupe constitué par Er³⁺, Sm³⁺, Pr³⁺ et Nd³⁺.

9. Laser selon la revendication 1, caractérisé par le fait que la concentration en ions de terre rare est supérieure à environ 10²¹ cm⁻³.

10. Laser selon la revendication 1, caractérisé par le fait que l'épaisseur de chaque sélecteur (20, 20') est inférieure ou égale à 300 µm.

11. Laser selon la revendication 1, caractérisé par le fait que le produit P de la concentration en ions de terre rare par l'épaisseur d'un sélecteur est supérieure à environ 10²¹ cm⁻².

12. Laser selon la revendication 1, caractérisé par le fait que le milieu amplificateur (10) comprend une hétérostructure ayant deux faces recouvertes d'une couche anti-reflet (18, 18'), les deux matériaux sélecteurs (20, 20') étant disposés respectivement entre une couche anti-reflet (18, 18') et un miroir (24, 24').

13. Laser selon la revendication 12, caractérisé par le fait que chaque sélecteur (20, 20') est au contact avec une des couches anti-reflet (18, 18').

14. Laser selon la revendication 13, caractérisé par le fait que chaque sélecteur (20, 20') est au contact avec un miroir (24, 24').

15. Laser selon la revendication 12, caractérisé par le fait que les deux sélecteurs (20, 20') sont au contact des couches anti-reflet (18, 18'), les deux miroirs (24, 24') du laser étant déposés sur les deux sélecteurs (20, 20').

## Claims

1. Semiconductor laser, comprising:
- an amplifier medium (10) having a given amplification gain (G) in a given wavelength range,
- at least one mirror (22),
- at least one wavelength selector consisting of a material containing rare earth, this selector being arranged between the mirror (22) and the amplifier medium (12), this material having an absorption spectrum (A) with a dip at a given wavelength which lies in the amplification range, this dip corresponding to an absorption less than the amplification gain of the amplifier medium (10),
characterized in that it comprises two selectors consisting of two different materials (20, 20') containing rare earths, these two materials having two absorption spectra (A, B) having two dips which are shifted relative to one another, these two materials together giving a spectrum (C) defining an overall absorption dip defining a wavelength (λ0) constituting the emission wavelength of the laser.

2. Laser according to Claim 1, characterized in that the absorption dip of each selector has a given width (Δλ) at a height equal to 1.1 DO min, DO min being the optical density at the absorption minimum, the inverse (M=1/ (Δλ)) of this width being at least equal to 2.10⁶ cm⁻¹.

3. Laser according to Claim 1, characterized in that the two materials (20, 20') consist of the same matrix with two different types of rare earth ions for the two materials.

4. Laser according to Claim 1, characterized in that the two materials (20, 20') consist of the same type of rare earth ions and two different matrices for the two materials.

5. Laser according to Claim 1, characterized in that it contains a single material (20) consisting of a matrix containing a mixture of ions of two different rare earths.

6. Laser according to Claim 1, characterized in that the material of each selector is a crystal doped with rare earth ions.

7. Laser according to Claim 1, characterized in that the material of each selector is a glass doped with rare earth ions.

8. Laser according to any one of Claims 1 to 6, characterized in that the rare earth ions are taken from the group consisting of Er³⁺, Sm³⁺, Pr³⁺ and Nd³⁺.

9. Laser according to Claim 1, characterized in that the rare earth ion concentration is greater than about 10²¹ cm⁻³.

10. Laser according to Claim 1, characterized in that the thickness of each selector (20, 20') is less than or equal to 300 µm.

11. Laser according to Claim 1, characterized in that the product P of the rare earth ion concentration times the thickness of a selector is greater than about 10²¹ cm⁻².

12. Laser according to Claim 1, characterized in that the amplifier medium (10) comprises a heterostructure having two faces covered with an anti-reflection layer (18, 18'), the two selector materials (20,20') being respectively arranged between an anti-reflection layer (18, 18') and a mirror (24, 24').

13. Laser according to Claim 12, characterized in that each selector (20, 20') is in contact with one of the anti-reflection layers (18, 18').

14. Laser according to Claim 13, characterized in that each selector (20, 20') is in contact with a mirror (24, 24').

15. Laser according to Claim 12, characterized in that the two selectors (20, 20') are in contact with the anti-reflection layers (18, 18'), the two mirrors (24, 24') of the laser being deposited on the two selectors (20, 20').

## Patentansprüche

1. Halbleiterlaser, umfassend:
- ein Verstärkermedium (10) mit einer bestimmten Verstärkungsleistung (G) in einem bestimmten Wellenlängenbereich,
- wenigstens einen Spiegel (22),
- wenigstens einen Wellenlängenselektor, gebildet durch ein eine seltene Erde enthaltendes Material, wobei dieser Selektor angeordnet ist zwischen dem Spiegel (22) und dem Verstärkermedium (12) und besagtes Material ein Absorptionsspektrum (A) mit einem Kurven-Tal bei einer bestimmten Wellenlänge aufweist, die in den Verstärkungsbereich fällt und dieses Tal dabei einer Absorption entspricht, die kleiner ist als die Verstärkungsleistung des Verstärkermediums (10),
**dadurch gekennzeichnet,**
daß er zwei Selektoren umfaßt, gebildet durch zwei unterschiedliche, seltene Erden enthaltende Materialien (20, 20'), wobei diese beiden Materialien zwei Absorptionsspektren (A, B) haben, die zwei gegeneinander verschobene Täler aufweisen und die Anordnung mit diesen beiden Materialien ein Spektrum (C) liefert, das ein globales Absorptions-Tal definiert, das eine Wellenlänge (λ0) abgrenzt, die die Emissionswellenlänge des Lasers ist.

2. Laser nach Anspruch 1, dadurch gekennzeichnet, daß das Absorptions-Tal jedes Selektors auf gleicher Höhe mit 1,1 DOmin eine bestimmte Breite (Δλ) aufweist, wobei DOmin die optische Dichte im Absorptionsminimum ist, und der Kehrwert (M=1/(Δλ)) dieser Breite wenigstens gleich 2.10⁶cm⁻¹ ist.

3. Laser nach Anspruch 1, dadurch gekennzeichnet, daß die beiden Materialien (20, 20') gebildet werden durch dieselbe Matrix mit zwei unterschiedlichen Typen von Ionen seltener Erden für die beiden Materialien.

4. Laser nach Anspruch 1, dadurch gekennzeichnet, daß die beiden Materialien (20, 20') gebildet werden durch denselben Typ von Ionen seltener Erden und zwei unterschiedlichen Matrizen für die beiden Materialien.

5. Laser nach Anspruch 1, dadurch gekennzeichnet, daß er ein einziges Material (20) umfaßt, gebildet durch eine Matrix, die eine Mischung aus Ionen von zwei unterschiedlichen seltenen Erden enthält.

6. Laser nach Anspruch 1, dadurch gekennzeichnet, daß das Material von jedem Selektor ein mittels Ionen seltener Erden dotierter Kristall ist.

7. Laser nach Anspruch 1, dadurch gekennzeichnet, daß das Material von jedem Selektor ein mittels Ionen seltener Erden dotiertes Glas ist.

8. Laser nach einem der Ansprüche 1 bis 6, dadurch gekennzeichnet, daß die Ionen seltener Erden gewählt werden aus der Gruppe, die gebildet wird durch Er³⁺, Sm³⁺, Pr³⁺ und Nd³⁺.

9. Laser nach Anspruch 1, dadurch gekennzeichnet, daß die Konzentration von Ionen seltener Erden höher ist als 10²¹ cm⁻³.

10. Laser nach Anspruch 1, dadurch gekennzeichnet, daß die Dicke jedes Selektors (20, 20') kleiner oder gleich 300µm ist.

11. Laser nach Anspruch 1, dadurch gekennzeichnet, daß das Produkt P der Konzentration von Ionen seltener Erden größer ist als ungefähr 10²¹ cm⁻².

12. Laser nach Anspruch 1, dadurch gekennzeichnet, daß das Verstärkermedium (10) eine Heterostuktur umfaßt, die zwei Flächen bzw. Seiten aufweist, die bedeckt sind mit einer Antireflex-Schicht (18, 18'), wobei die beiden Selektorenmaterialien (20, 20') jeweils zwischen einer Antireflex-Schicht (18, 18') und einem Spiegel (24, 24') angeordnet sind.

13. Laser nach Anspruch 12, dadurch gekennzeichnet, daß jeder Selektor (20, 20') in Kontakt ist mit einer der Antireflex-Schichten (18, 18').

14. Laser nach Anspruch 13, dadurch gekennzeichnet, daß jeder Selektor (20, 20') in Kontakt ist mit einem Spiegel (24, 24').

15. Laser nach Anspruch 12, dadurch gekennzeichnet, daß die beiden Selektoren (20, 20') in Kontakt sind mit den Antireflex-Schichten (18, 18'), wobei die beiden Spiegel (24, 24') des Lasers auf den Selektoren (20, 20') abgeschieden sind.
